# FASCICULE DE BREVET EUROPEEN

(11) **EP 3 817 509 B1**
(45) Date de publication et mention de la délivrance du brevet: **25.06.2025**
(21) Numéro de dépôt: 20203056.5
(22) Date de dépôt: 21.10.2020
(51) Int. Cl.: H05B 1/02, H05B 3/84

(54) **PROCÉDÉ DE RÉGULATION D'UN ÉLÉMENT RÉSISTIF DESTINÉ À DÉGIVRER ET/OU DÉSEMBUER UN SUPPORT, ET LE DISPOSITIF ASSOCIÉ**
VERFAHREN ZUR REGULIERUNG EINES RESISTIVEN ELEMENTES, DAS ZUM AUFTAUEN UND/ODER ENTFROSTEN EINER HALTERUNG DIENT, UND ENTSPRECHENDE VORRICHTUNG
METHOD FOR CONTROLLING A RESISTIVE ELEMENT INTENDED FOR DE-ICING AND/OR DE-MISTING A MOUNTING, AND ASSOCIATED DEVICE

(30) Priorité: 28.10.2019 FR 1912031
(43) Date de publication de la demande: 05.05.2021
(73) Titulaire: Commissariat à l'Energie Atomique et aux Energies Alternatives, 75015 Paris (FR)
(72) Inventeur: ALAVA, Thomas, 38054 GRENOBLE CEDEX 09 (FR); HAN, Zheng, 38054 GRENOBLE CEDEX 09 (FR)
(74) Mandataire: Brevalex

(56) Documents cités:
- EP-A1- 3 013 119
- EP-A1- 3 070 995
- WO-A1-2018/210763
- CN-A- 105 539 368
- DE-A1- 102011 121 921
- DE-A1- 2 405 230
- KR-A- 20180 088 006
- US-A1- 2014 074 351

## Description

### DOMAINE TECHNIQUE

La présente invention concerne un procédé de régulation d'un élément résistif destiné à dégivrer et/ou désembuer un support, notamment la surface d'un support, et plus particulièrement la surface d'un support transparent dans le domaine visible.

La présente invention peut être mise en œuvre pour le dégivrage d'une vitre de voiture, notamment son pare-brise avant et/ou la lunette arrière, pour le dégivrage d'une visière d'un masque ou d'un casque.

Le procédé selon la présente invention prévoit notamment une optimisation de la consommation énergétique de l'élément résistif.

### ÉTAT DE LA TECHNIQUE ANTÉRIEURE

Le dégivrage de la lunette arrière d'un véhicule automobile est généralement assuré par un élément résistif. Cet élément résistif peut notamment comprendre des fils ou des bandes métalliques (ci-après « fils ») parallèles en eux/elles sur toute la longueur ou la largeur de la lunette arrière.

En fonctionnement, les fils, lorsqu'ils sont parcourus par un courant électrique, dissipent une quantité de chaleur permettant de faire fondre du givre susceptible d'être présent sur un moins l'une de la face intérieure et de la face extérieure de la lunette arrière.

Les systèmes de dégivrage des véhicules automobiles sont généralement commandés par un commutateur marche/arrêt, opéré par l'utilisateur (notamment le conducteur du véhicule automobile). En d'autres termes, la mise en route du système de dégivrage nécessite une action volontaire de l'utilisateur tant pour sa mise en route que pour son arrêt.

Ce type de système n'est toutefois pas satisfaisant.

En effet, l'action volontaire de mise en marche et d'arrêt du système de dégivrage se fait sur la base d'un critère subjectif qui ne permet pas d'optimiser sa consommation énergétique.

Par ailleurs, il arrive que le système de dégivrage soit laissé en marche par simple oubli du conducteur.

Par ailleurs, un système de dégivrage mettant en œuvre des fils obstrue partiellement la visibilité du conducteur de sorte que la mise en œuvre de ces derniers pour le dégivrage du pare-brise (avant) d'un véhicule automobile, ou d'une visière d'un masque ou d'un casque, ne peut être facilement envisagée.

Afin de pallier ces problèmes, et à tout le moins celui relatif à la visibilité du conducteur, il a pu être envisagé de remplacer les fils par un élément résistif fait d'un oxyde transparent conducteur, et notamment de l'oxyde d'indium et d'étain. Cependant, ce dernier composé, bien que présentant une transparence appropriée, reste très fragile.

Par ailleurs, les matériaux permettant de fabriquer de tels oxydes ne sont pas suffisamment abondants.

La réalisation de l'élément résistif avec des nano fils de carbone ou d'argent tissés selon un réseau à 3 dimensions permet également de répondre à la problématique de transparence. Cependant, une mise en production en série d'éléments résistifs faits de ces nano fils n'est pas envisageable à l'heure actuelle.

Les propriétés de transparence du graphène, ainsi que la maîtrise de sa mise en œuvre, font de ce matériau un candidat de choix pour les systèmes de dégivrage.

À cet égard, les documents [1], [2] et [3] cités à la fin de la description divulguent des éléments résistifs faits de graphène.

Le document DE 10 2011 121921 A1 divulgue un procédé de régulation d'un système de dégivrage selon le préambule de la revendication 1.

Toutefois, aucun de ces documents n'adresse les problèmes associés à l'optimisation, et notamment la réduction, de la consommation énergétique d'un système de dégivrage.

Un but de la présente invention est donc de proposer un procédé de régulation d'un système de dégivrage, et le système de dégivrage, permettant de mieux contrôler la consommation énergétique dudit système de dégivrage.

Un autre but de la présente invention est également de proposer un procédé de régulation d'un système de dégivrage, et un système de dégivrage, permettant de faire fonctionner ledit système de manière autonome, et sur des critères objectifs.

Un autre but de la présente invention est également de proposer un procédé de régulation d'un système de dégivrage.

### EXPOSÉ DE L'INVENTION

Les buts de la présente invention sont, au moins en partie, atteints par un procédé de régulation, au moyen d'un calculateur, d'un élément résistif agencé pour dégivrer et/ou désembuer un support, le procédé comprenant :
a) une boucle de surveillance de la température T et du taux d'humidité H au niveau du support ;
b) une séquence de dégivrage et/ou de désembuage qui, tant que la température T et le taux d'humidité H surveillés par la boucle de surveillance a) sont indicatifs d'une absence de givre ou de buée sur le support, maintient l'élément résistif inactif, et dans le cas contraire commande, lors d'une étape b2), la circulation d'un courant I dans l'élément résistif de sorte que ce dernier dissipe une puissance thermique Pₜₕ, ajustée en fonction de la température T et le taux d'humidité H, et permettant le dégivrage ou le désembuage du support selon une durée prédéterminée Dₚ, avantageusement inférieure à 2 secondes,
dans lequel la séquence de dégivrage b) comprend :
b1) une étape de détermination de la puissance thermique Pₜₕ sur la base de la température T et du taux d'humidité H surveillés par la boucle a) exécutée avant l'étape b2),
et dans lequel l'élément résistif comprend un empilement de couches formé par une première couche et une seconde couche séparées par une couche isolante, la première couche comprenant un matériau bidimensionnel à résistance variable sous l'effet d'un champ électrique et est destinée à dissiper la puissance thermique Pₜₕ ajustée, tandis que la seconde couche comprend un matériau résistif et est destinée, dès lors qu'elle est soumise à un potentiel électrique V_{g}, à imposer un champ électrique à la première couche, la séquence dégivrage b) comprenant également une étape b3), exécutée avant l'étape b1), de détermination de la résistance R de la première couche traversée par un courant I connu en fonction de potentiels V_{g} appliqués à la seconde couche.

Ainsi le procédé selon la présente invention permet de contrôler selon des critères objectifs, et de manière répétable, la mise en marche et l'arrêt de l'élément résistif.

Il en résulte une optimisation de la consommation énergétique, notamment dans un véhicule automobile dans lequel la seule réserve d'énergie est la batterie.

Selon un mode de mise en œuvre, la boucle de surveillance a) comprend :
a1) une étape de mesure de la température T et de l'humidité H ;
a2) une étape de détermination de la présence ou non de givre ou de buée sur le support en fonction de la température T et du taux d'humidité H mesurés à l'étape a1).

Selon un mode de mise en œuvre, la boucle de surveillance a) est exécutée périodiquement, avantageusement toutes les deux secondes.

Selon un mode de mise en œuvre, l'étape b1) est exécutée au moyen d'un abaque stocké dans un espace mémoire du calculateur, et permettant de déterminer la puissance thermique Pₜₕ en fonction de la température T et le taux d'humidité H.

Selon un mode de mise en œuvre, les épaisseurs de la première et de la seconde couche sont ajustées de sorte que la transparence de l'élément résistif dans le domaine visible soit supérieure à 80%.

Ainsi, le procédé de régulation, ainsi que l'élément résistif, peuvent être mis en œuvre sur le pare-brise avant d'un véhicule automobile sans perturber la visibilité du conducteur.

Selon un mode de mise en œuvre, le matériau résistif est également un matériau bidimensionnel à résistance variable sous l'effet d'un champ électrique.

Selon un mode de mise en œuvre, la séquence dégivrage b) comprend également une étape b3), exécutée avant l'étape b1), de détermination de la résistance R de la première couche en fonction d'un potentiel Vg appliqué à la seconde couche.

Selon un mode de mise en œuvre, l'ajustement de la puissance thermique Pₜₕ comprend un ajustement du potentiel électrique V_{g}.

Selon un mode de mise en œuvre, l'élément résistif est formé sur une face exposée du support.

Selon un mode de mise en œuvre, le support comprend un empilement de deux couches, dites couches support, entre lesquelles vient s'intercaler l'élément résistif.

Selon un mode de mise en œuvre, le support est transparent dans le domaine visible, notamment le support comprend soit une vitre d'un véhicule automobile, soit une visière d'un casque, soit une visière d'un masque.

Selon un mode de mise en œuvre, la boucle de surveillance a) est également exécutée au moyen d'un capteur de température et d'humidité disposé sur ou dans le support.

L'invention concerne également un programme d'ordinateur comprenant des instructions qui, lorsque le programme est exécuté par un calculateur, conduisent celui-ci à mettre en œuvre le procédé de régulation selon la présente invention.

L'invention concerne également un élément résistif agencé pour dégivrer et/ou désembuer un support, et contrôlé par un calculateur sur lequel est stocké le programme d'ordinateur selon la présente invention.

Selon un mode de mise en œuvre, le matériau résistif est également un matériau bidimensionnel à résistance variable sous l'effet d'un champ électrique.

### BRÈVE DESCRIPTION DES DESSINS

D'autres caractéristiques et avantages apparaîtront dans la description qui va suivre du procédé de régulation d'un élément résistif selon l'invention, donnés à titre d'exemples non limitatifs, en référence aux dessins annexés dans lesquels :
La figure 1 est une représentation schématique d'un élément résistif couplé à un support, et destiné à être mis en œuvre dans la présente invention, l'élément résistif comprend notamment un empilement de couches intercalé entre deux couches support ;
La figure 2 est une représentation graphique de la résistivité (axe vertical, « R » en « Ohms ») d'une première monocouche de graphène d'une seconde monocouche de graphène par un matériau diélectrique, en fonction d'un potentiel de grille Vg (axe horizontal, « Vg » en « Volts ») auquel est soumis ladite seconde couche pour une température et un taux d'humidité donné ;
La figure 3 est une représentation graphique de la dérivée première de la résistivité (axe vertical, « dR/dVg ») représentée à la figure 2, en fonction du potentiel de grille (axe horizontal, « Vg ») ;
La figure 4 est une représentation schématique de l'enchaînement des étapes du procédé de régulation de l'élément résistif selon la présente invention ;
La figure 5 est une représentation schématique d'un capteur de température fait de graphène et susceptible d'être mis en œuvre pour déterminer la température du support lors de l'exécution du procédé de régulation de l'élément résistif ;
La figure 6 est une représentation schématique de l'interfaçage du calculateur avec le ou les capteur(s) et l'élément résistif ;
La figure 7 est une représentation graphique du diagramme de Mollier relatif au changement d'état liquide et vapeur de l'eau ;

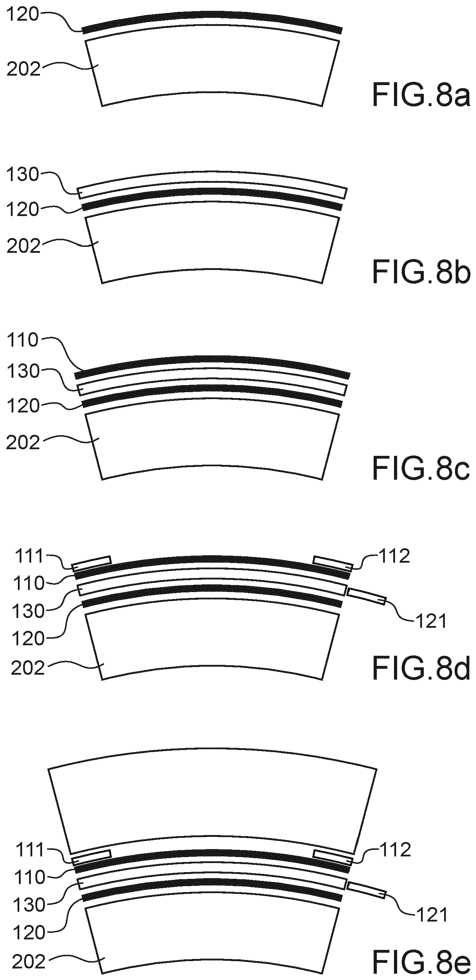

Les figures 8a, 8b, 8c, 8d, 8e sont des représentations schématiques d'un procédé de fabrication de l'élément résistif susceptible d'être mis en œuvre dans le cadre de la présente invention.

### EXPOSÉ DÉTAILLÉ DE MODES DE RÉALISATION PARTICULIERS

La présente invention concerne un procédé de régulation d'un élément résistif destiné à dégivrer et/ou à désembuer un support auquel il est associé.

En particulier, le procédé de régulation est mis en œuvre au moyen d'un calculateur qui exécute une boucle de surveillance de la température T et du taux d'humidité du support, et plus particulièrement d'une surface dudit support.

La boucle de surveillance selon la présente invention permet notamment de détecter, en fonction de la température T et du taux d'humidité H, la présence de givre et /ou de buée sur le support.

Le calculateur peut également mettre en œuvre, dès lors que la température T et le taux d'humidité H indiquent la présence de givre et/ou d'humidité sur le support, une boucle de dégivrage et/ou de désembuage.

Plus particulièrement, selon la présente invention, la boucle de dégivrage et/ou de désembuage commande l'élément résistif de sorte que ce dernier délivre une puissance thermique Pₜₕ, ajustée en fonction de la température T et le taux d'humidité H, et permettant le dégivrage ou le désembuage du support selon une durée prédéterminée Dₚ, avantageusement inférieure à 2 secondes.

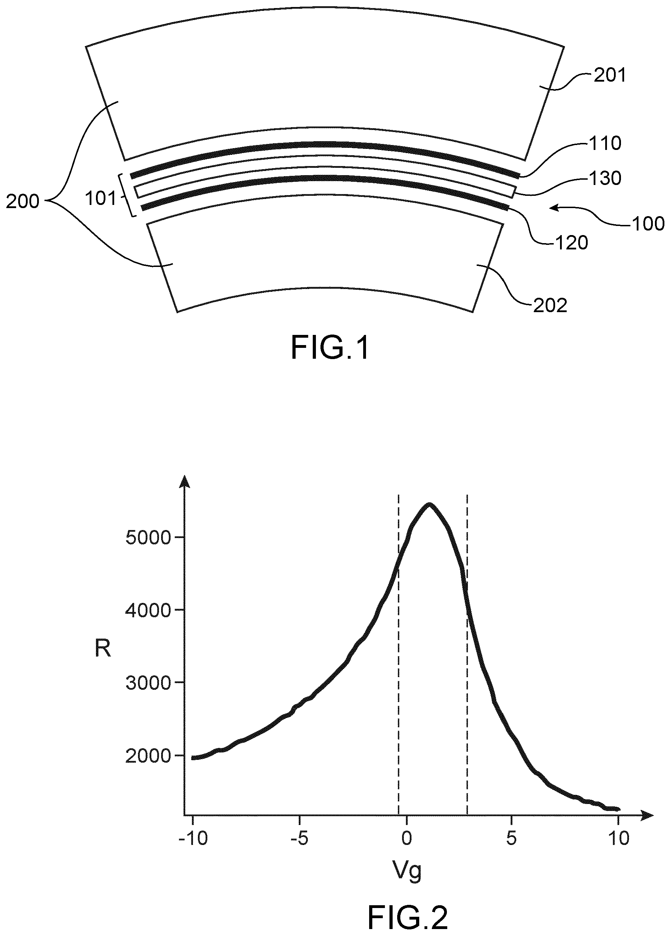

La figure 1 est une représentation schématique d'un élément résistif 100 susceptible d'être mis en œuvre dans le cadre de la présente invention.

L'élément résistif 100, selon la présente invention, est un élément qui lorsqu'il est parcouru par un courant électrique I dissipe une puissance thermique (donc de la chaleur) destinée à dégivrer et/ou désembuer un support 200.

À cet égard, l'élément résistif 100 peut comprendre des fils métalliques disposés sur une face exposée du support 200.

De manière alternative, l'élément résistif 100 peut comprendre une couche ou un empilement de couches qui est/sont, selon une première variante, en recouvrement d'une face exposée du support 200, et selon une deuxième variante dans le volume du support 200.

Plus particulièrement, selon la deuxième variante, le support 200 comprend deux couches, dites couches support 201 et 202, entre lesquelles vient s'intercaler l'élément résistif.

Le support 200 est avantageusement transparent dans le domaine visible.

Par « transparent dans le domaine visible », on entend un coefficient de transmission supérieur à 80%, avantageusement 90 %, encore plus avantageusement 95%, dans le domaine visible.

Par « domaine visible », on entend le domaine de longueurs d'onde comprises entre 400 nm et 750 nm.

Le support 200 peut être rigide, et comprendre par exemple du verre, du quartz.

De manière alternative, le support 200 peut être flexible et comprendre un matériau polyimide, ou du polydiméthylsiloxane, ou du polyméthacrylate de méthyle (PMMA).

Plus particulièrement, le support 200 peut être une visière d'un masque ou d'un casque, une vitre d'un véhicule automobile, par exemple un pare-brise ou une lunette arrière.

Selon l'invention, l'élément résistif 100 comprend un empilement de couches 101 formé par une première couche 110 et une seconde couche 120 séparées par une couche isolante 130.

Par « couche isolante », on entend une couche qui est électriquement isolante, et qui, par voie de conséquence, garantit une isolation électrique entre la première couche 110 et la seconde couche 120.

La couche isolante 130 peut notamment comprendre un matériau diélectrique, par exemple un verre ou du dioxyde de silicium ou de l'oxyde d'Hafnium.

L'épaisseur de la couche isolante peut être comprise entre 100 nm et 100 µm.

La première couche 110 est un matériau bidimensionnel.

Par « matériau bidimensionnel », on entend un matériau qui présente une structure cristalline à 2 dimensions. De tels matériaux comprennent en général un empilement de plans cristallins au sein desquels les atomes ou molécules sont liés par des liaisons covalentes, tandis des interactions du type Van der Walls assurent la cohésion entre plans cristallins.

Le matériau bidimensionnel formant la première couche 110 présente également une résistance électrique variable en fonction d'un champ électrique auquel il est susceptible d'être soumis.

En d'autres termes, il est possible de moduler la résistance électrique de la première couche 110 en fonction d'un champ électrique imposé dans son environnement proche.

Les matériaux susceptibles de répondre aux deux critères susmentionnés sont connus de l'homme du métier, et peuvent comprendre au moins un des éléments choisis parmi : graphène, MoS₂, MOSe₂, WS₂, WSe₂.

L'épaisseur de la première couche 110 est ajustée par l'homme du métier en fonction des propriétés de transparence qu'il souhaite conférer à cette dernière. Par exemple, la première couche 110 peut comprendre entre une et dix couches atomiques du matériau bidimensionnel à résistance variable.

Plus particulièrement, les épaisseurs de la première couche 110 et de la seconde couche 120 sont ajustées de sorte que la transparence de l'élément résistif 100 dans le domaine visible soit supérieure à 80 %, avantageusement supérieure à 90 %, encore plus avantageusement supérieure à 95 %.

La seconde couche 120 comprend un matériau résistif, par exemple un oxyde transparent conducteur, ou un matériau bidimensionnel à résistance variable.

Une première couche 110 et une seconde couche 120 faites du même matériau est toutefois préférable.

La seconde couche 120 est notamment agencée pour, lorsqu'elle est soumise à un potentiel Vg donné (également appelé « potentiel de grille »), imposer un champ électrique à la première couche 110.

En d'autres termes, le potentiel Vg imposé à la seconde couche permet de faire varier la résistance électrique de la première couche 110.

À cet égard, la figure 2 est une représentation graphique de la résistance électrique R d'une première couche 110 faite de graphène en fonction du potentiel de grille Vg imposé à une seconde couche faite également de graphène.

La résistance électrique de la première couche décrit une courbe en forme de cloche et présente un maximum.

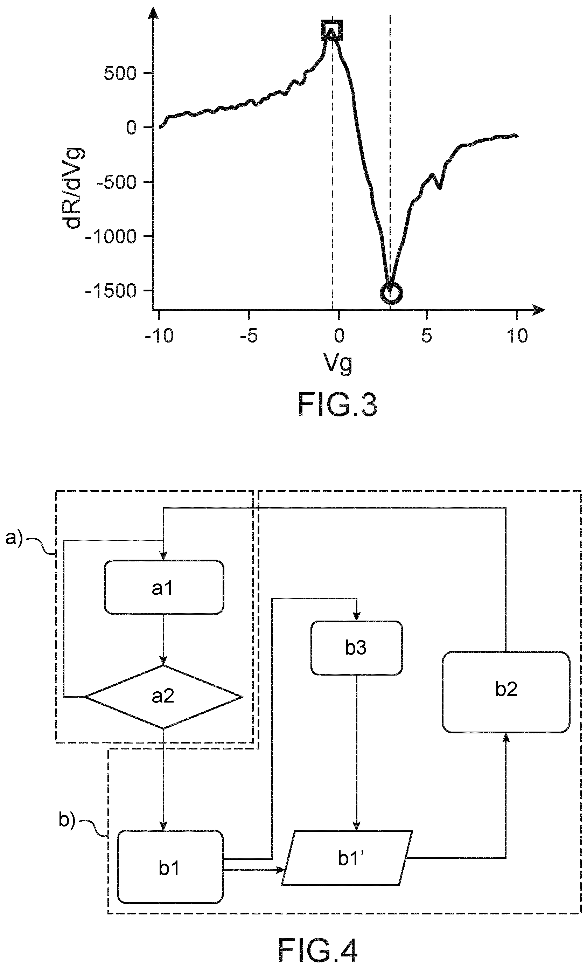

Cette courbe d'évolution de la résistance électrique en forme de cloche présente également deux points d'inflexion révélés par la dérivée première de la résistance en fonction du potentiel de grille (figure 3).

La suite de la description est limitée à un élément résistif qui comprend une première couche et une seconde couche faites de graphène et entre lesquelles vient s'intercaler une couche de matériau diélectrique tel que du dioxyde de silicium.

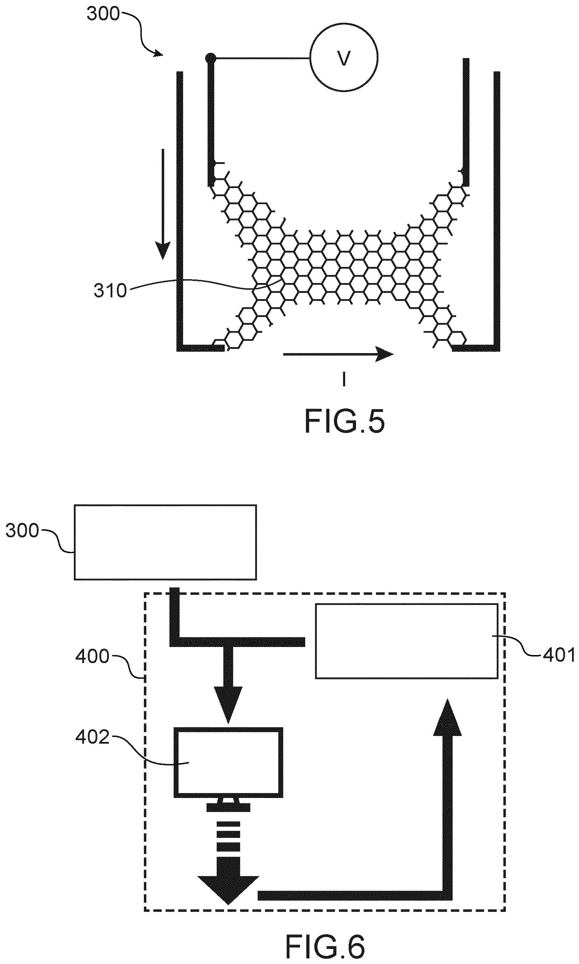

Le procédé de régulation (illustré à la figure 4) de l'élément résistif 100 est exécuté au moyen d'un calculateur 400 (figure 6).

Par « calculateur », on entend un dispositif pourvu d'un processeur capable d'exécuter des commandes, et notamment les commandes d'un programme informatique stockées par exemple dans un espace mémoire dédié dudit calculateur 400.

Le procédé de régulation de l'élément résistif, illustré à la figure 4, selon la présente invention comprend une boucle de surveillance a) de la température T et du taux d'humidité H au niveau du support 200.

Il est entendu qu'une « boucle », selon les termes de la présente invention comprend une ou plusieurs étape(s) et se répète, par exemple à intervalles de temps réguliers. L'exécution d'une boucle peut être soumise à conditions.

La boucle de surveillance a) peut être exécutée à intervalles de temps réguliers (ou périodiquement), par exemple toutes les minutes ou toutes les trente secondes, ou toutes les cinq secondes.

La boucle de surveillance a) peut comprendre une étape a1) de mesure de la température T et du taux d'humidité H.

L'étape a1) peut être exécutée au moyen d'un ou plusieurs capteurs 300 de température et/ou d'humidité.

À titre d'exemple la figure 5 représente un capteur 300, notamment un capteur de température.

Ce capteur 300 comprend notamment une mono couche de graphène 310. La dépendance en température de la résistance électrique du graphène en fait un matériau de choix pour la mise en œuvre dans un capteur de température.

La détermination de la température avec un tel capteur 300, comprend une mesure de la tension électrique V entre deux bornes formées sur le graphène lorsque ce dernier est traversé par un courant électrique d'une intensité I connue.

Le document [4] cité à la fin de la description décrit un exemple d'un tel capteur de température susceptible d'être mis en œuvre dans le cadre de la présente invention.

Le capteur 300 peut être disposé sur ou dans le support 200, et ainsi permettre une estimation fidèle de la température T et/ou du taux d'humidité H dudit support 200.

La boucle de surveillance a) peut également comprendre une étape a2) de détermination de la présence ou non de givre et/ou de buée sur le support en fonction de la température T et le taux d'humidité H mesurés sur le support 200 lors de l'étape a1).

Le procédé de régulation comprend également une séquence b) de dégivrage et / ou désembuage.

En particulier, dès lors que la température T et le taux d'humidité H surveillés à l'étape a) sont indicatifs de la présence de givre et/ou de buée, la séquence b) commande, lors d'une étape b2), l'injection d'un courant électrique I dans l'élément résistif 100 de sorte que ce dernier dissipe une puissance thermique Pₜₕ, ajustée en fonction de la température T et du taux d'humidité H, et permettant le dégivrage ou le désembuage du support pendant la durée prédéterminée Dₚ.

La durée prédéterminée est avantageusement inférieure à 20 secondes, encore plus avantageusement inférieure à 5 secondes, et préférablement inférieure à 2 secondes.

Il est entendu, sans qu'il soit nécessaire de le préciser, que l'élément résistif 100 est associé à une source de courant. Cette dernière peut, par exemple, être intégrée au calculateur 400.

En absence de givre et / ou de buée, la séquence b) laisse l'élément résistif 100 inactif. En d'autres termes, aucun courant électrique ne circule dans l'élément résistif 100.

Il est donc entendu que l'entrée dans la séquence de dégivrage et/ou de désembuage est conditionnée à la présence de givre et/ou de buée sur le support, et que le procédé de régulation de l'élément résistif sort de ladite séquence dès lors que la température T et le taux d'humidité H sur le support ne sont plus indicatifs de la présence de givre et/ou de buée sur ledit support.

Le courant électrique I, dans le cadre de l'empilement de couches considéré, circule dans la première couche 110.

L'ajustement de la puissance thermique Pₜₕ (étape b1), figure 4) comprend avantageusement un ajustement du potentiel de grille Vg (étape b1'), figure 4) imposé à la seconde couche 120. Plus particulièrement, le potentiel de grille Vg est ajusté de sorte que la première couche 110 présente une résistance électrique Rₜₕ au passage du courant électrique I permettant la dissipation de la puissance thermique Pₜₙ pendant la durée prédéterminée Dₚ.

En d'autres termes, la mise en œuvre d'une première couche comprenant un matériau bidimensionnel à résistance variable permet de considérer une source de courant électrique fixe.

La détermination de la puissance thermique Pₜₕ peut être exécutée sur la base d'une simulation numérique ou de calculs *ab initio* qui sont à la portée du l'homme du métier.

De manière alternative, la détermination de la puissance thermique Pₜₕ peut mettre en œuvre une courbe d'étalonnage ou un abaque stocké dans un espace mémoire du calculateur 400.

L'abaque considéré permet de déterminer, à partir de la température T et du taux d'humidité H, la puissance thermique Pₜₕ nécessaire à la fonte du givre ou à l'évaporation de la buée susceptible de s'être formé(e) sur le support.

Cet abaque peut notamment être construit expérimentalement.

La construction de l'abaque peut comprendre la détermination de la puissance thermique Pₜₕ nécessaire la fonte du givre ou à l'évaporation de la buée susceptible de s'être formé(e) sur le support à une température T et un taux d'humidité H donnés.

En particulier, la détermination de la puissance thermique Pₜₕ peut comprendre la mesure du temps requis pour faire fondre du givre ou évaporer de la buée lorsque la première couche 110 est parcourue par un courant I.

Cette étape peut comprendre une simple observation de la disparition complète du givre ou de la buée, et se conclu par une mesure de la température T et du taux d'humidité du support 200.

Ce protocole peut être répété autant de fois que nécessaire et pour différents couples de température T et de taux d'humidité H.

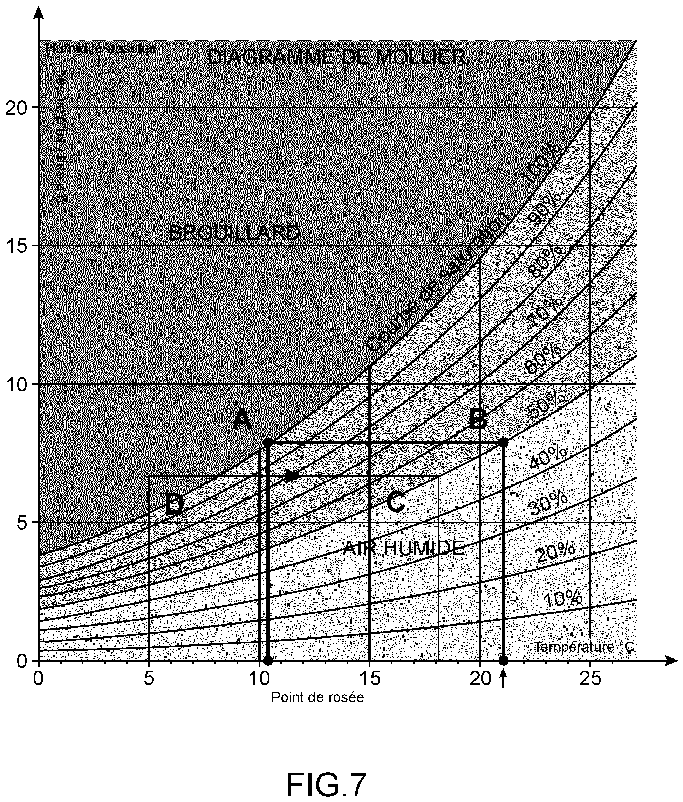

À titre d'exemple, le diagramme de Mollier représenté à la figure 7 peut être considéré. Ce diagramme est une représentation graphique des changements d'état liquide gazeux de l'eau au niveau d'une surface en fonction de la température (en « °C » selon l'axe horizontal) et le taux d'humidité absolue (en « g d'eau / kg d'air sec » selon l'axe vertical).

Au point « B » de ce diagramme, la température et l'humidité définissent une saturation d'eau gazeuse dans l'air de 50%. Ainsi, si pour un taux d'humidité absolue constant la température diminue, par exemple à la température définie par le point « A », un phénomène de condensation de l'eau se produit, et de l'eau liquide se forme sur la surface considérée (il s'agit du point de rosée).

Maintenant, s'il s'agit de désembuer la surface considérée par exemple soumise à des conditions de température et d'humidité absolue associées au point « D » du diagramme de Mollier, il peut être arbitrairement choisi par l'homme du métier de déterminer la puissance thermique Pₜₕ permettant de chauffer la surface considérée à une température correspondant à un taux d'humidité dans l'air égal à 50%. En d'autres termes, tel que représenté sur le diagramme de Mollier de la figure 7, il peut être considéré de déterminer la puissance thermique nécessaire pour chauffer la surface à la température associée au point « C ».

Dans ces conditions, la puissance Pₜₕ nécessaire au désembuage peut être déterminée comme suit :
- imposer une tension de grille Vg à la seconde couche 120 de manière de sorte que la première couche 110 présente une résistance électrique Rₜₕ au passage du courant électrique,
- appliquer un courant fixe et noter un temps t_{c} à partir duquel la buée au niveau de la surface considérée disparait.

Le temps t_{c}, la résistance électrique Rₜₕ ainsi que le courant fixe permettent alors de déterminer la puissance Pₜₕ requise pour désembuer la surface dans des conditions de température et d'humidité particulières.

Ces opérations peuvent être répétées autant de fois que nécessaire pour déterminer la puissance nécessaire au désembuage pour différents couples de température et d'humidité absolue.

La procédure décrite ci-avant permet alors de construire l'abaque suivant :
Il est toutefois notable que les valeurs données dans le tableau suivant sont établi au regard d'un choix arbitraire d'humidité de l'air. Les valeurs représentent une tendance d'une case à l'autre, et l'autre du métier en modifiant le critère relatif à l'humidité pour construire un autre abaque.

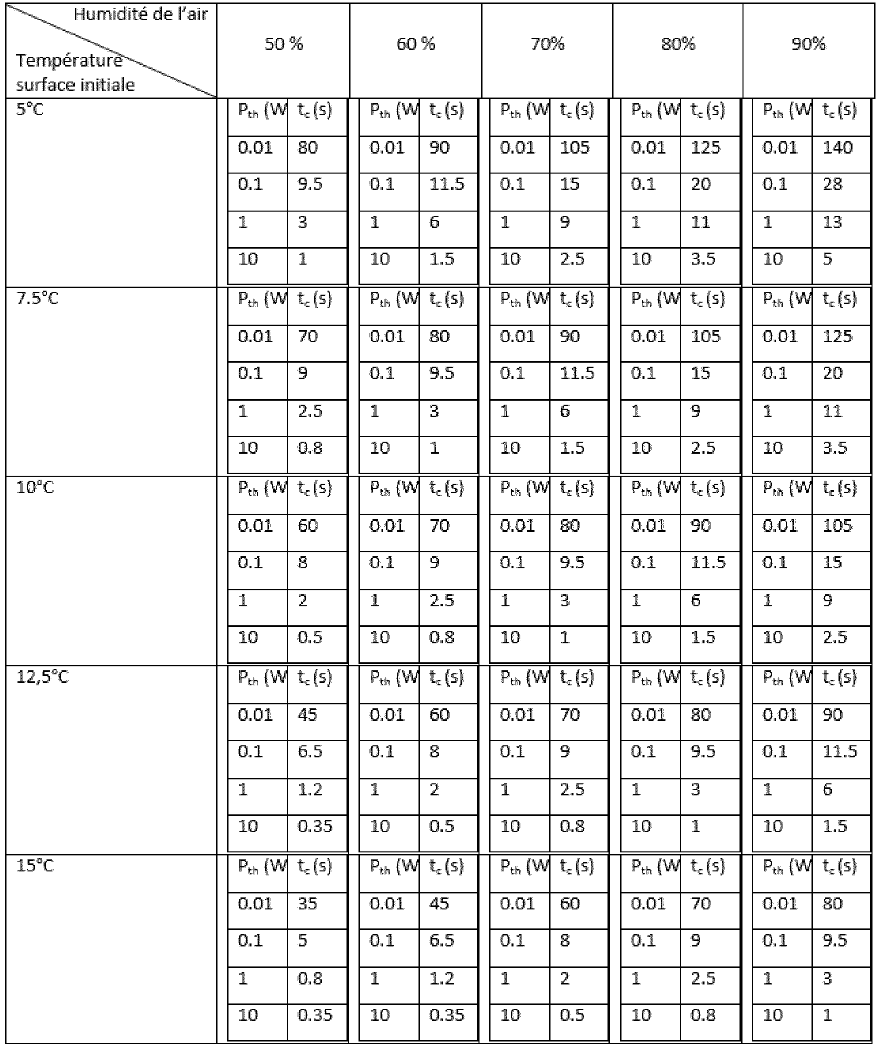

Le procédé de régulation selon la présente invention permet donc d'optimiser la puissance thermique nécessaire au dégivrage et au désembuage d'un support 200.

La mise en route et l'arrêt de l'élément résistif en fonction d'une éventuelle formation de givre ou de buée sur le support est exécutée de manière automatique sur des critères objectifs et répétables, et ne nécessitent donc plus l'intervention d'un opérateur.

La considération d'une première couche 110 et d'une seconde couche 120 transparentes permet d'envisager la mise en œuvre de l'élément résistif selon la présente invention également pour le dégivrage d'un pare-brise d'un véhicule automobile, ou d'une visière d'un masque ou d'un casque.

La séquence de dégivrage b) comprend également une étape b3) de détermination de la résistance électrique R de la première couche 110 en fonction du potentiel de grille Vg susceptible d'être appliqué à la seconde couche 120.

En particulier, l'étape b3) comprend une acquisition par le calculateur 400 de la tension V au niveau de deux bornes de la première couche traversée par un courant électrique I connue, et pour différentes valeurs de potentiel de grille Vg.

La présente invention concerne également un programme d'ordinateur, qui lorsqu'il est exécuté par un calculateur 400, conduit celui-ci à mettre en œuvre le procédé de régulation de l'élément résistif 100.

La présente invention concerne également l'élément résistif pour dégivrer et/ou désembuer un support, et contrôlé par le calculateur 400 sur lequel est stocké le programme d'ordinateur.

En particulier, l'élément résistif comprend l'empilement de couches 101 formé par la première couche 110 et la seconde couche 120 séparées par la couche isolante 130.

La première couche peut comprendre un matériau bidimensionnel à résistance variable sous l'effet d'un champ électrique et est destinée à dissiper la puissance thermique Pₜₕ ajustée, tandis que la seconde couche peut comprendre un matériau résistif et est destinée, dès lors qu'elle est soumise à un potentiel électrique V_{g}, à imposer un champ électrique à la première couche.

Par ailleurs, les épaisseurs de la première 110 et de la seconde couche 120 peuvent être ajustées de sorte que la transparence de l'élément résistif dans le domaine visible soit supérieure à 80%.

En outre, le matériau résistif peut également comprendre un matériau bidimensionnel à résistance variable sous l'effet d'un champ électrique.

Selon une première variante, l'élément résistif est formé sur une face exposée du support.

Selon une deuxième variante, le support comprend deux couches, dites couches support, entre lesquelles vient s'intercaler l'élément résistif.

Enfin, le support peut être transparent dans le domaine visible, notamment le support peut comprendre soit une vitre d'un véhicule automobile, soit une visière d'un casque, soit une visière d'un masque.

Les figures 7a à 7e représentent un exemple de procédé de fabrication de l'élément résistif dans un support 200 pourvu de deux couches support 201 et 202. Le support 200 est en particulier un pare-brise.

Le procédé comprend une première étape 1) de formation de la seconde couche 120 sur une des couches support, par exemple la couche support 202.

La seconde couche peut comprendre du graphène par dispersion (« spray coating » selon la terminologie Anglo-Saxonne).

La première étape 1) est suivie d'une deuxième étape 2) de formation de la couche isolante 130. La couche isolante 130 peut comprendre du SiO₂, du HfO₂ et être formée par une technique de dépôt en phase vapeur (« CVD » ou « Chemical Vapor Deposition » selon la terminologie Anglo-Saxonne).

Une troisième étape 3) de formation de la première couche 110 en recouvrement de la couche isolante 130 est ensuite exécutée selon les mêmes modalités que la première étape.

Des contacts de sources 111 et de drain 112 d'une part, de grille 121 d'autre part, sont formés, respectivement sur la première couche 110 et sur la deuxième couche 120 lors d'une quatrième étape 4).

L'étape 4) est alors suivie d'une cinquième étape 5) de recouvrement de la première couche 110 par la couche support 201.

En complément, un ou des capteurs de température et/ou de taux d'humidité peuvent être formés sur le support.

L'élément résistif 100, et éventuellement le ou les capteurs 300 peuvent être interfacés avec le calculateur 400.

Le calculateur 400 peut notamment comprendre une unité d'exécution 401, destinée à mettre en œuvre la séquence b), et une unité de traitement des données 402 destinée à collecter la température et le taux d'humidité mesuré par le ou les capteurs 300, et déterminer les conditions de mise en œuvre de la séquence de dégivrage et/ou de désembuage.

### REFERENCES

[1] US 2014/0021195,
[2] WO 2016062885,
[3] US 8,431,869,
[4] Davaji B et al., "A patterned single layer graphene resistance temperature sensor", Scientific Reports 7, 8811 (2017).

## Revendications

1. Procédé de régulation, au moyen d'un calculateur, d'un élément résistif (100) agencé pour dégivrer et/ou désembuer un support (200), le procédé comprenant :
a) une boucle de surveillance de la température T et du taux d'humidité H au niveau du support (200) ;
b) une séquence de dégivrage et/ou de désembuage qui, tant que la température T et le taux d'humidité H surveillés par la boucle de surveillance a) sont indicatifs d'une absence de givre ou de buée sur le support (200), maintient l'élément résistif (100) inactif, et dans le cas contraire commande, lors d'une étape b2), la circulation d'un courant I dans l'élément résistif (100) de sorte que ce dernier dissipe une puissance thermique Pₜₕ, ajustée en fonction de la température T et le taux d'humidité H, et permettant le dégivrage ou le désembuage du support (200) selon une durée prédéterminée Dₚ, avantageusement inférieure à 2 secondes,
dans lequel la séquence de dégivrage b) comprend :
b1) une étape de détermination de la puissance thermique Pₜₕ sur la base de la température T et du taux d'humidité H surveillés par la boucle a) exécutée avant l'étape b2),
**caractérisé en ce que** l'élément résistif (100) comprend un empilement de couches (101) formé par une première couche (110) et une seconde couche (120) séparées par une couche isolante (130), la première couche (110) comprenant un matériau bidimensionnel à résistance variable sous l'effet d'un champ électrique et est destinée à dissiper la puissance thermique Pₜₕ ajustée, tandis que la seconde couche (120) comprend un matériau résistif et est destinée, dès lors qu'elle est soumise à un potentiel électrique V_{g}, à imposer un champ électrique à la première couche (110), la séquence dégivrage b) comprenant également une étape b3), exécutée avant l'étape b1), de détermination de la résistance R de la première couche (110) traversée par un courant I connu en fonction de potentiels Vg appliqués à la seconde couche (120).

2. Procédé selon la revendication 1, dans lequel la boucle de surveillance a) comprend :
a1) une étape de mesure de la température T et de l'humidité H ;
a2) une étape de détermination de la présence ou non de givre ou de buée sur le support (200) en fonction de la température T et du taux d'humidité H mesurés à l'étape a1).

3. Procédé selon la revendication 1 ou 2, dans lequel la boucle de surveillance a) est exécutée périodiquement, avantageusement toutes les deux secondes.

4. Procédé selon l'une des revendications 1 à 3, dans lequel l'étape b1) est exécutée au moyen d'un abaque stocké dans un espace mémoire du calculateur (400), et permettant de déterminer la puissance thermique Pₜₕ en fonction de la température T et le taux d'humidité H.

5. Procédé selon l'une des revendications 1 à 4, dans lequel l'ajustement de la puissance thermique Pₜₕ comprend un ajustement du potentiel électrique V_{g}.

6. Procédé selon l'une des revendications 1 à 5, dans lequel la boucle de surveillance a) est également exécutée au moyen d'un capteur (300) de température et d'humidité disposé sur ou dans le support (200).

7. Programme d'ordinateur comprenant des instructions qui, lorsque le programme est exécuté par un calculateur (400), conduisent celui-ci à mettre en œuvre le procédé selon l'une des revendications 1 à 6.

8. Dispositif pourvu d'un élément résistif (100) agencé pour dégivrer et/ou désembuer un support (200), et d'un calculateur (400) sur lequel est stocké le programme d'ordinateur selon la revendication 7, ledit calculateur (400) étant destiné à réguler l'élément résistif (100), dans lequel l'élément résistif (100) comprend un empilement de couches formé par une première couche (110) et une seconde couche (120) séparées par une couche isolante (130), la première couche (110) comprenant un matériau bidimensionnel à résistance variable sous l'effet d'un champ électrique et est destinée à dissiper la puissance thermique Pₜₕ ajustée, tandis que la seconde couche (120) comprend un matériau résistif et est destinée, dès lors qu'elle est soumise à un potentiel électrique V_{g}, à imposer un champ électrique à la première couche (110).

9. Dispositif selon la revendication 8, dans lequel les épaisseurs de la première et de la seconde couche (120) sont ajustées de sorte que la transparence de l'élément résistif (100) dans le domaine visible soit supérieure à 80%.

10. Dispositif selon la revendication 8 ou 9, dans lequel le matériau résistif est également un matériau bidimensionnel à résistance variable sous l'effet d'un champ électrique.

## Patentansprüche

1. Regelverfahren mittels eines Rechners für ein Widerstandselement (100), das zum Enteisen und/oder Entnebeln eines Trägers (200) angeordnet ist, wobei das Verfahren Folgendes umfasst:
a) eine Überwachungsschleife für die Temperatur T und den Feuchtigkeitsgehalt H am Träger (200);
b) eine Enteisungs- und/oder Entnebelungssequenz, die, solange die von der Überwachungsschleife überwachte Temperatur T und der Feuchtigkeitsgehalt H a) auf das Fehlen von Eis oder Nebel auf dem Träger (200) hindeuten, das Widerstandselement (100) inaktiv hält und andernfalls in einem Schritt b2) den Fluss eines Stroms I in dem Widerstandselement (100) steuert, so dass dieses eine thermische Leistung Pₜₕ abführt, die in Abhängigkeit von der Temperatur T und dem Feuchtigkeitsgehalt H angepasst ist und das Enteisen oder Entnebeln des Trägers (200) nach einer vorbestimmten Zeit Dₚ ermöglicht, vorteilhafterweise weniger als 2 Sekunden,
wobei die Enteisungssequenz b) Folgendes umfasst:
b1) einen Schritt zur Bestimmung der Wärmeleistung Pₜₕ auf der Grundlage der Temperatur T und des Feuchtigkeitsgehalts H, die von der Schleife a) überwacht werden, der vor Schritt b2) durchgeführt wird,
**dadurch gekennzeichnet, dass**
das Widerstandselement (100) einen Stapel von Schichten (101) umfasst, der durch eine erste Schicht (110) und eine zweite Schicht (120) gebildet ist, die durch eine Isolierschicht (130) getrennt sind, wobei die erste Schicht (110) ein zweidimensionales Material mit variablem Widerstand unter der Wirkung eines elektrischen Feldes umfasst und dazu bestimmt ist, die angepasste thermische Leistung Pₜₕ abzuführen, während die zweite Schicht (120) ein ohmsches Material umfasst und dazu bestimmt ist, sobald sie einem elektrischen Potenzial V_{g} ausgesetzt ist, der ersten Schicht (110) ein elektrisches Feld aufzuprägen, wobei die Enteisungssequenz b) auch einen vor dem Schritt b1) durchgeführten Schritt b3) zur Bestimmung des Widerstands R der ersten Schicht (110), durch die ein bekannter Strom I fließt, als Funktion der an die zweite Schicht (120) angelegten Potentiale V_{g} umfasst.

2. Verfahren nach Anspruch 1, wobei die Überwachungsschleife a) Folgendes umfasst:
a1) einen Schritt der Messung der Temperatur T und der Luftfeuchtigkeit H;
a2) einen Schritt zur Bestimmung des Vorhandenseins oder Nichtvorhandenseins von Eis oder Nebel auf dem Träger (200) in Abhängigkeit von der in Schritt a1) gemessenen Temperatur T und dem Feuchtigkeitsgehalt H.

3. Verfahren nach Anspruch 1 oder 2, wobei die Überwachungsschleife a) periodisch, vorteilhafterweise alle zwei Sekunden, ausgeführt wird.

4. Verfahren nach einem der Ansprüche 1 bis 3, wobei der Schritt b1) mittels eines Diagramms ausgeführt wird, das in einem Speicherplatz des Rechners (400) gespeichert ist und die Bestimmung der thermischen Leistung Pₜₕ in Abhängigkeit von der Temperatur T und dem Feuchtigkeitsgehalt H ermöglicht.

5. Verfahren nach einem der Ansprüche 1 bis 4, wobei die Anpassung der thermischen Leistung Pₜₕ eine Anpassung des elektrischen Potenzials V_{g} umfasst.

6. Verfahren nach einem der Ansprüche 1 bis 5, wobei die Überwachungsschleife a) auch mittels eines Temperatur- und Feuchtigkeitssensors (300) durchgeführt wird, der auf oder in dem Träger (200) angeordnet ist.

7. Computerprogramm, das Anweisungen umfasst, die, wenn das Programm von einem Rechner (400) ausgeführt wird, dazu führen, dass dieses das Verfahren nach einem der Ansprüche 1 bis 6 umsetzt.

8. Vorrichtung mit einem Widerstandselement (100), das zum Enteisen und/oder Entnebeln eines Trägers (200) angeordnet ist, und einem Rechner (400), auf dem das Computerprogramm nach Anspruch 7 gespeichert ist, wobei der Rechner (400) zur Regelung des Widerstandselements (100) bestimmt ist,
wobei das Widerstandselement (100) einen Stapel von Schichten umfasst, der durch eine erste Schicht (110) und eine zweite Schicht (120) gebildet ist, die durch eine Isolierschicht (130) getrennt sind, wobei die erste Schicht (110) ein zweidimensionales Material mit variablem Widerstand unter der Wirkung eines elektrischen Feldes umfasst und dazu bestimmt ist, die angepasste thermische Leistung Pₜₕ abzuführen, während die zweite Schicht (120) ein Widerstandsmaterial umfasst und dazu bestimmt ist, wenn sie einem elektrischen Potenzial V_{g} ausgesetzt ist, ein elektrisches Feld auf die erste Schicht (110) aufzuzwingen.

9. Vorrichtung nach Anspruch 8, wobei die Dicke der ersten und zweiten Schicht (120) so eingestellt ist, dass die Transparenz des Widerstandselements (100) im sichtbaren Bereich größer als 80 % ist.

10. Vorrichtung nach Anspruch 8 oder 9, wobei das Widerstandsmaterial auch ein zweidimensionales Material mit variablem Widerstand unter Einwirkung eines elektrischen Feldes ist.

## Claims

1. A method for regulating, by means of a computer, a resistive element (100) arranged to deice and/or demist a support (200), the method comprising:
a) a loop for monitoring the temperature T and the moisture level H at the support (200) ;
b) a deicing and/or demisting sequence which, as long as the temperature T and the moisture level H monitored by the monitoring loop a) are indicative of an absence of frost or mist on the support (200), keeps the resistive element (100) inactive and, in the contrary case, demands, in a step b2), the circulation of a current I in the resistive element (100) so that the latter dissipates a thermal power Pₜₕ, adjusted according to the temperature T and the moisture level H, and allowing deicing or demisting of the support (200) over a predetermined period Dₚ,
wherein the deicing sequence b) comprises:
b1) a step of determining the thermal power Pₜₕ on the basis of the temperature T and the moisture level H monitored by the loop a) executed before step b2),
**characterized in that** the resistive element (100) comprises a stack of layers (101) formed by a first layer (110) and a second layer (120) separated by an insulating layer (130), the first layer comprising a two-dimensional material with resistance that is variable under the effect of an electrical field and is intended to dissipate the adjusted thermal power Pₜₕ, while the second layer (120) comprises a resistive material and is intended, as soon as it is subjected to an electrical potential V_{g}, to impose an electrical field on the first layer, the deicing sequence b) also comprises a step b3), executed before step b1), of determining the resistance R of the first layer as a function of a potential Vg applied to the second layer (120).

2. The method according to claim 1, wherein the monitoring loop a) comprises;
a1) a step of measuring the temperature T and the humidity H;
a2) a step of determining the presence or not of frost or mist on the support according to the temperature T and the moisture level H measured at step a1).

3. The method according to claim 1 or 2, wherein the monitoring loop a) is executed periodically.

4. The method according to any of the claims 1 to 3, wherein step b1) is executed by means of a nomogram stored in a memory space of the computer (400), and making it possible to determine the thermal power Pₜₕ as a function of the temperature T and the moisture level H.

5. The method according to any of the claims 1 to 4, wherein the adjustment of the thermal power Pₜₕ comprises an adjustment of the electrical potential V_{g}.

6. The method according to any of the claims 1 to 5, wherein the monitoring loop a) is also executed by means of a temperature and moisture sensor (300) disposed on or in the support (200).

7. A computer program comprising instructions which, when the program is executed by a computer (400), lead the latter to implement the method according to any of the claims 1 to 6.

8. A device provided with a resistive element (100) arranged to deice and/or demist a support (200), and a computer (400) on which the computer program according to claim 7 is stored, said computer being intended to regulate the resistive element (100), wherein the resistive element comprises a stack of layers formed by a first layer and a second layer (120) separated by an insulating layer, the first layer comprising a two-dimensional material with resistance that is variable under the effect of an electrical field and is intended to dissipate the adjusted thermal power Pₜₕ, while the second layer (120) comprises a resistive material and is intended, as soon as it is subjected to an electrical potential V_{g}, to impose an electrical field on the first layer (110).

9. The device according to claim 8, wherein the thicknesses of the first and second layer (120) are adjusted to that the transparency of the resistive element in the visible domain is greater than 80%.

10. The device according to claim 8 or 9, wherein the resistive material is also a two-dimensional material with resistance that is under the effect of an electrical field.
